# EUROPEAN PATENT APPLICATION

(11) **EP 1 369 912 A2**
(43) Date of publication of application: **10.12.2003**
(21) Application number: 03006161.8
(22) Date of filing: 19.03.2003
(51) Int. Cl.: H01L 21/60, H01L 25/065

(54) **Method of mounting a Flip chip using a laser beam**

(30) Priority: 03.06.2002 US 161430
(71) Applicant: ROBERT BOSCH GMBH, 70442 Stuttgart (DE)
(72) Inventor: Lutz, Markus, Sunnyvale, California 94086 (US); Hack, Ruediger, Santa Rosa, California 95404 (US)

(57) **Abstract**

Method for bonding a chip (20) to a chip carrier (21) including arranging the chip (20) in alignment with the chip carrier (21) to form a chip stack. First bond area situated on the chip at an interface between the chip (20) and the chip carrier (21) in contact with second bond area situated on the chip carrier (21) at the interface. Projecting a laser beam (25) through the chip (20) and/or the chip carrier (21), the laser beam (25) impinging on the first bond area and/or the second bond area melting the first bond area and/or the second bond area to form a bond electrically coupling the chip (20) and the chip carrier (21). A device including a chip (20) having a first bond area situated on a chip carrier side of the chip and a chip carrier (21) having a second bond area situated on a chip side of the chip carrier (21). The contact area less than about 40 µm². A system for bonding a chip (20) to a chip carrier (21) including a laser (25) and an aperture for holding a chip stack in alignment. The chip stack includes a chip (20) and a chip carrier (21). The laser (25) is directed and/or focused by the aperture. The laser projects a laser beam through the chip (20) and /or the chip carrier (21) which impinges on the first bond area and/or the second bond area. The first bond area situated on a chip carrier side of the chip (20) and the second bond area situated on a chip side of the chip carrier (21). The first bond area area contacting the second bond area. The first bond area is bonded to the second bond area by the laser beam (25) impinging on the first bond area and/or the second bond area.

## Description

### Field Of The Invention

The present invention generally regards the field of chip bonding. More particularly, the present invention regards bonding a flip chip to a carrier chip using localized laser energy.

### Background Information

Integrated circuits may be printed on silicon chips or wafers using various photolithographic and etching techniques. These integrated circuits may be connected to a package, another chip, a carrier chip, or any other type of substrate, by conventional means including solder connections or bond wires. The solder connections may include solder balls formed on large bond pads using thick and thin film technologies or galvanic processes to print/deposit the required solder paste/metal. Typical ball sizes may be 200µm in diameter and the distance to avoid short circuits between two balls may be 75µm. Solder areas may not have active structures (e.g. transistors) beneath them. A conventional method of electrically connecting an integrated circuit and a package may be to align the solder balls of the chip with bond pads on the package to form a chip stack and then to heat the entire chip stack to a temperature at which the solder balls melt. Additionally, mechanical pressure may be applied to the chip stack to increase tolerance for imperfections in the construction and/or alignment of the solder balls and/or bond pads. Heating the chip stack may induce mechanical stress on the wafer due to the interaction of materials having different thermal expansion coefficients. This induced mechanical stress may limit the size of the stack which may be created by this method. The size of the solder balls and the distance between these connections may limit the number of connections between the chip and the chip carrier.

In general, the focusability of a laser beam is determined by its wavelength and its beam quality. At a given wavelength, a better beam quality implies a more focusable laser beam. M² is a beam parameter which descn'bes the beam quality and therefore the focusability of a beam. M² = 1 is the theoretical physical limit for a beam's beam quality at a given wavelength for a refraction limited beam. To focus a beam to the smallest possible spot size, the beam quality should be as close to M² = 1 as possible. A refraction limited beam has a beam mode at the physical limit in terms of focusability; higher focusability may only be achieved by shortening the laser wave length.

Therefore, what is needed is a method of connecting a wafer to a package or another chip that does not induce mechanical stress and which enables a higher density of connections to the package or other chip.

### Summary Of The Invention

A method for bonding a chip to a chip carrier, another chip, and/or a package using laser-induced metal bonding technology is provided. Localized heating of bonding areas allows smaller bonding areas and less space between the bonding areas (i.e. the pitch) and therefore provides more space on the chip for active components (e.g. transistors).

The method for bonding a chip to a chip carrier which is provided includes arranging the chip in alignment with the chip carrier to form a chip stack. A first bond area situated on the chip at an interface between the chip and the chip carrier contacts a second bond area situated on the chip carrier at the interface. A laser beam is projected through the chip and/or the chip carrier and impinges on the first bond area and/or the second bond area. The laser beam melts the first bond area and/or the second bond area to form a bond which electrically couples the chip and the chip carrier.

A device is provided which includes a chip having a first bond area situated on a chip carrier side of the chip and a chip carrier having a second bond area situated on a chip side of the chip carrier The first bond area is bonded to the second bond to form a contact area. The contact area may be less than about 4 µm².

A system for bonding a chip to a chip carrier is provided which includes a laser and an aperture for holding a chip stack in alignment. The chip stack includes a chip and a chip carrier. The laser is directed and/or focused by the aperture. The laser projects a laser beam through the chip and/or the chip carrier which impinges on the first bond area and/or the second bond area. The first bond area is situated on a chip carrier side of the chip and the second bond area is situated on a chip side of the chip carrier. The first bond area contacts the second bond area. The first bond area is bonded to the second bond area by the laser beam impinging on the first bond area and/or the second bond area.

The method according to the present invention may have the following advantages: the soldering heat is only locally or partially induced in the contact area; thermal expansion is very localized during the process which leads to less stress in the system; the contact area may be reduced to about 4 µm² using a new fiber laser which allows a high power beam focused on small area (up to 100 watts for spot sizes of 10 µm²); the location of the contact may be anywhere on the chip (therefore less chip area may be dedicated to wiring); the metal used for the bonding may be deposited and patterned like any conductive pad in IC processes.

### Brief Description Of The Drawings

Figure 1 is a schematic diagram illustrating a cross-sectional view of a wafer including integrated circuitry and showing bonding pads.
Figure 2 is a schematic diagram illustrating a cross-sectional view of a wafer including bond areas in contact with bonding areas of a chip carrier.
Figure 3 is a schematic diagram illustrating a cross-sectional view of a multiple chip stack including bond areas and illustrating laser beam projections.
Figure 4 is a flowchart illustrating a method according to an exemplary embodiment of the present invention.
Figure 5 is a schematic diagram illustrating a system for bonding a chip stack and illustrating laser beam projections.
Figure 6 is a schematic diagram illustrating a relationship between bond area size and laser spot size.

### Detailed Description

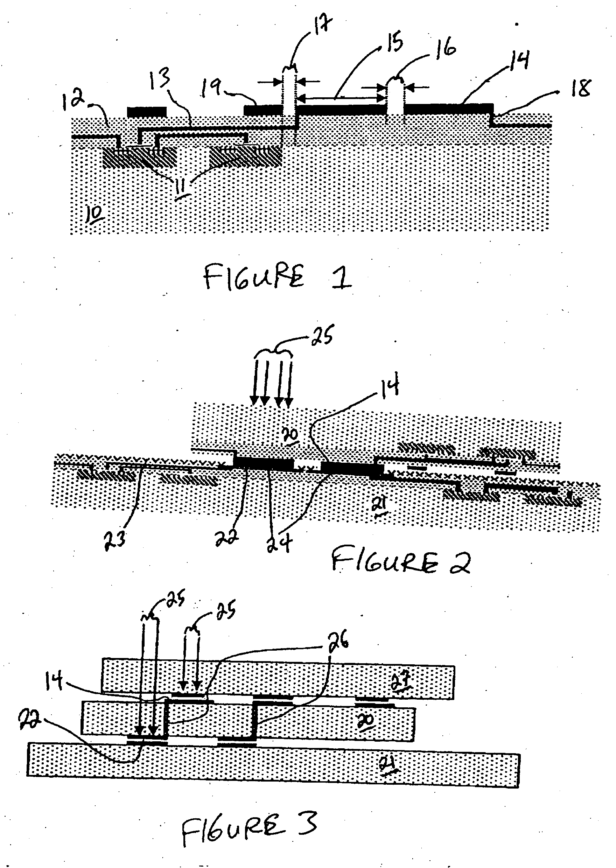

Figure 1 illustrates a wafer including integrated circuitry and showing bonding pads. Wafer substrate 10 includes active IC (integrated circuit) structures 11 (e.g. transistors), dielectric layer 12 (e.g. SiO2) between conductive Al layers 13 (which may be conductive paths), metal layer 14 (which may be the top layer) for laser bonding, and additional conductive paths 19. Additional conductive layers 18 may connect metal layer 14 to other areas of wafer substrate 10, other IC structures, and/or other bonding areas. The process of making this structure may involve depositing metal layer 14 (e.g. AL, AISi, AlSiCu, Cu, Ge, etc.) as a thick layer on top of a finished IC on the wafer and then patterning metal layer 14. Alternatively, the last metal layer from the IC process may be used for bonding. Size 15 of the bonding pad formed from metal layer 14 may be as small as a laser spot or even smaller (e.g. 1 µm to 30 µm). Distance 16 between the bonding pads and the next conductive path or second distance 17 between the conductive path and the active structure may be very small, because the laser beam may be aligned with an accuracy of about 1 µm, and the laser beam may only be absorbed by metal layer 14 and not be absorbed by Si or dielectric layer 12 which underlies metal layer 14. The chip carrier may be a PCB, wafer, or another chip.

Figure 2 illustrates a wafer including bond areas in contact with bonding areas of a chip carrier. Second chip 20 is bonded to carrier chip 21. Opening 24 in passivation layer 23 exposes top metal layer 22 which may be used to bond second chip 20 to carrier chip 21 and to make electric contact between the integrated circuits or conduction paths within the chips. The bonding is activated by laser beam 25 which may be absorbed only by metal layer 14 and/or top metal layer 22. Laser beam 25 melts metal layer 14 and/or top metal layer 22 bonding metal layer 14 and top metal layer 22 together. Alternatively, one of metal layer 14 and top metal layer 22 may be absent and the other of metal layer 14 and top metal layer 22 may contact the silicon wafer of the chip or chip carrier. In this instance, laser beam 25 may melt metal layer 14 or top metal layer 22 to the silicon of the chip or chip carrier. This may lead to a very low contact resistance (which may be desirable for RF, analog, high-end, low power, and/or other devices) between second chip 20 and carrier chip 21.

Laser beam 25 may be focused to a beam diameter less than 20µm and may be aligned very accurately (approximately 1 µm), which may ensure that only the target bonding area is heated up. Also the laser wavelength used may not be absorbed by the Si of either second chip 20 or carrier chip 21, which may cause a very localized heat spot which may reduce the effect of the heat on the electronic circuit on second chip 20 and/or carrier chip 21.

In an exemplary embodiment, the laser source should have a wavelength for which the chip base material and the dielectric layer is transparent. The bond area material or an intermediate bonding layer should absorb the laser wavelength and eventually reach an activation level and start the bonding process (i.e. melting). Some chip building materials (e.g. Si and Al) provide such a behavior for laser wavelengths of 1.2 micron to 2 microns. In addition a very high focusability (M² ∼ 1) is needed to reach minimal spot sizes. The laser intensities needed for a bonding process based on melting Al layers require laser power levels of 1 to 10 watts or higher. Any laser source meeting the above-mentioned parameters may be acceptable. In particular, Ytterbium-Erbium Fiber Lasers may fulfill these requirements with a small system size, high efficiency, and low cost.

Laser beam 25 is illustrated as projecting through second chip 20. However, in alternative embodiments, laser beam 25 may be projected through carrier chip 21 to heat up the bonding area. Carrier chip 21 may be any or all of a printed circuit board with bond areas which are compatible to the metal on second chip 20; a ceramic thick film substrate which may be used in, for example, automotive and RF applications; or any chip carrier which has suitable areas for bonding.

Figure 3 is a schematic diagram illustrating a cross-sectional view of a chip stack of three chips bonded together including bond areas and illustrating laser beam projections. Using interconnects through the wafer, the process according to an exemplary embodiment of the present invention may be used to build chip stacks with multiple chips bonded together. Carrier chip 21 is the base carrier, which is bonded with interface bond . areas 22 to the bottom of second chip 20. Second chip 20 has interconnects 26 which connect the chip surface with the bottom of second chip 20. Third chip 27 is bonded upside down on second chip 20. Depending on the layout and alignment capability, the actual bonding process may be done as a whole stack or by bonding chip by chip.

Figure 3 shows that there is also the possibility to bond an interface bond area 22 of the lower two chips (i.e. second chip 20 and carrier chip 21) through the upper chip (i.e. third chip 27) by projecting laser beam 25 through both third chip 27 and second chip 20. Additionally, chip stacks with more than three chips with interconnects between each adjacent chip may also be made thereby enabling larger chip stacks.

In the laser induced bonding process illustrated in figures 1 to 3, laser beam 25 may be focused to a spot size of less than one micron up to 100 micron. Laser beam 25 may heat up the bond area by being absorbed by the bond area or an additional intermediate layer. In this manner, the bonding process (i.e. the bonding pads melting) may be localized to the laser spot area. The laser beam wavelength maybe absorbed by the bond areas and scattered or refracted by the Si layer and/or the dielectric layer. In this manner, laser beam 25 may heat up only the bonding area (e.g. the metal), but not heat up or damage other parts of the chip (e.g. the electronic circuit, etc.).

Laser power may be absorbed by the bonding material causing the bonding material to melt locally, thereby creating an electrical contact. The amount of laser power necessary for this purpose depends on the size of the area to be melted (i.e. the spot size), the laser light absorption rate of the bonding material, and the heat dissipation rate at the bonding area. Typical values for Al under very high heat dissipation conditions (e.g. solid Al) are 1 to 10 watts at a laser wavelength between 1.2 and 2 microns with spot sizes of 1 to 100 microns.

Rapid scanning of the laser beam power may enable precise control of the local amount of heat input necessary to create a sufficient bond. A closed loop control may be based on the input from a local (e.g. optical or infrared) temperature sensor detecting the melt temperature of the bond area. Some temperature sensors may need to be oriented to ' have an unobstructed line of sight (e.g. from the edge of the chip stack) with the bond, whereas other temperature sensors may be able to observe the melt from different angles. Altematively or additionally, closed loop control may be accomplished by activating the leads to the integrated circuit of the chip and/or substrate to measure the electrical resistance between the contacts to be bonded by the laser beam concurrent with the laser beam bonding the contacts. Additionally, the electrical resistance may be measured after projecting the laser beam as a method of evaluating the quality of the bond post production and determining whether further bonding is necessary.

Various bond patterns may be used in the method according to the present invention. For instance, single spots or grids of spots may be used. Bonds (i.e. pads) may be made by a single 1 micron to 100 micron spot of metal. A chip device may have a grid of several bond spots. This grid may be arranged in any pattern on the chip and/or wafer substrate and may be such that the laser beam illuminates and bonds several (or many) bond areas at one time. Moving the beam laterally over the device, or moving the device underneath the fixed laser beam, enables bonds to be created in 1 micron to 100 micron wide swaths. Alternatively, patterns of metal lines may be used to create bond lines using the method according to the present invention. At laser intensities of 1 watt to 10 watt per 1 micron to 100 micron spot size, melting temperatures may be reached within one millisecond. Scanner speeds may allow for several hundred bonds per second to be melted.

Alternatively, bonds in the form of patterns of 1 micron to 100 micron wide lines may be possible with line scanning speeds of up to 1000 millimeters per second. This process speed may be able to increase the cost effectiveness of the method according to the present invention. Scanning the laser beam laterally over the device or wafer surface by fast scanning optics may allow fast creation of grids of bond spots (i.e. pads) as well as patterns of bond lines without moving the device or whole wafer. Scanning focusing optics may allow spot sizes between 1 and 100 microns.

The laser induced bonding process may provide the capability to repair single non-functioning electric bonds created by conventional bonding technologies. The laser beam may locally heat up the metal layers or intermediate solder layer of the non-functioning bond areas causing a re-flow of the bonding material and improving the electrical coupling between the chip and the chip carrier.

Simultaneous bonding of all bond areas may compensate for bow and twist of the chip stack. Simultaneous bonding may be achieved by using multiple beams or by fast scanning of a single laser beam (e.g. faster than the thermal heat transfer). Additionally, a combination of simultaneous bonding using multiple beams and by fast scanning of beam may also be possible.

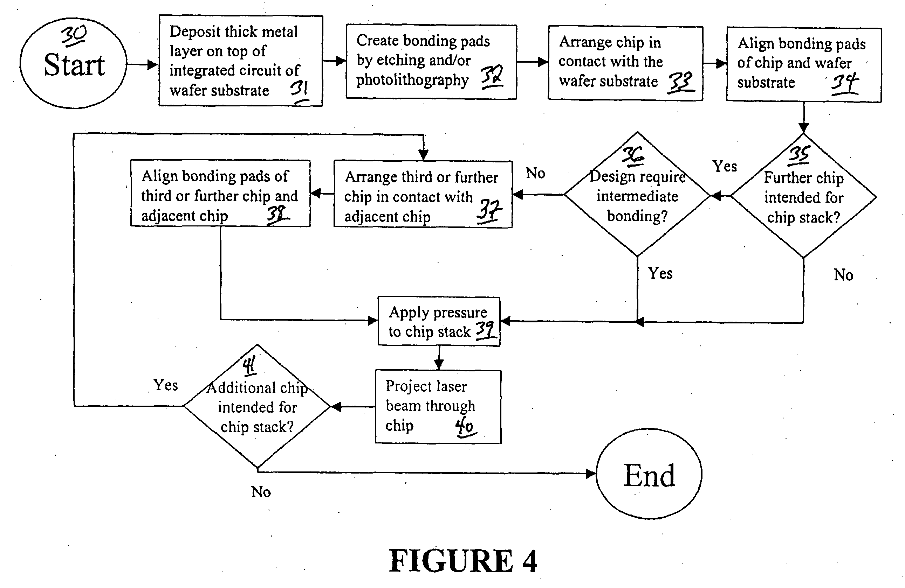

Figure 4 is a flowchart illustrating the process flow of a method according to the present invention for bonding a chip to a wafer or to another chip. The method starts with start 30 and proceeds to action 31 where a thick metal layer is deposited on top of an integrated circuit of a wafer substrate. The method proceeds to action 32 which indicates that bonding pads are created by etching and/or photolithography. From action 32, the flow proceeds to action 33, in which a chip is arranged in contact with the wafer substrate. The flow then proceeds to action 34, in which the bonding pads of the chip are aligned with the bonding pads of the wafer substrate. From action 34, the flow proceeds to question 35, which asks whether a further chip is intended for the chip stack. Question 35 ascertains whether the chip stack will have two chips or more than two chips. If the answer is yes indicating that more than two chips are destined for the chip stack, the flow proceeds to question 36, which asks whether the design requires intermediate bonding. Question 36 determines whether the chip stack as currently aligned, with two chips, will undergo bonding prior to adding more chips.

If the answer to question 36 is in the negative, then the flow proceeds to action 37, in which a third or further chip is arranged in contact with the adjacent chip. In one situation, this would involve a third chip being arranged on top of the chip on a side opposite the carrier chip. This results in a chip stack having the chip sandwiched between the carrier chip and the third chip. Alternatively, this may mean a fourth or subsequent chip is arranged on top of a chip stack already including a carrier chip on the bottom, a chip arranged on top of the carrier chip, a third chip arranged on the chip, and possibly additional chips arranged on the third chip. In action 38, the bonding pads of the third or further chip are aligned with the adjacent chip. From action 38, the flow proceeds to action 39, in which pressure is applied to the chip stack. Applying mechanical pressure to the chip stack may improve the contact between the bond areas of adjacent chips and may increase the tolerances for the production of the chips and the bond areas. Mechanical pressure may also improve the quality of the bonds created by the process.

From action 39, the flow proceeds to action 40, in which a laser beam is projected through the chip. As indicated above, in alternative embodiments the laser beam may be projected through the chip carrier. Additionally, as indicated above, the laser may be any type of laser including a fiber laser. The laser may be projected through the chip (or chip carrier) at an angle slightly less than 90 degrees. A slight variation from an orthogonal projection may provide the most effective illumination of the bond area while avoiding damage to the laser due to reflection of the laser beam back at the laser. As noted above, the laser may be scanned or pulsed over different bonding pads, and may be repeatedly scanned or pulsed over the same set of bonding pads to induce simultaneous bonding. Additionally, multiple lasers may be utilized to induce simultaneous bonding and/or to increase the production speed for the bonding process. From action 40, the flow proceeds to question 41, which asks whether an additional chip is intended for the chip stack. If more chips are intended for the chip stack, the flow proceeds to action 37 where the flow proceeds in the manner described above by arranging another chip on the adjacent (i.e. the top) chip. If no more chips are intended for the chip stack, the flow proceeds to end 42.

From question 35, if the response is in the negative and therefore no further chips are intended for the chip stack, the flow proceeds to action 39 where mechanical pressure is applied to the chip stack. From there, the flow proceeds as described above. Similarly, from question 36, if the response is in the affirmative, in which an intermediate bonding step is required, then the flow also proceeds to action 39, in which mechanical pressure is applied to the chip stack. Again, from action 39 the flow proceeds as described above.

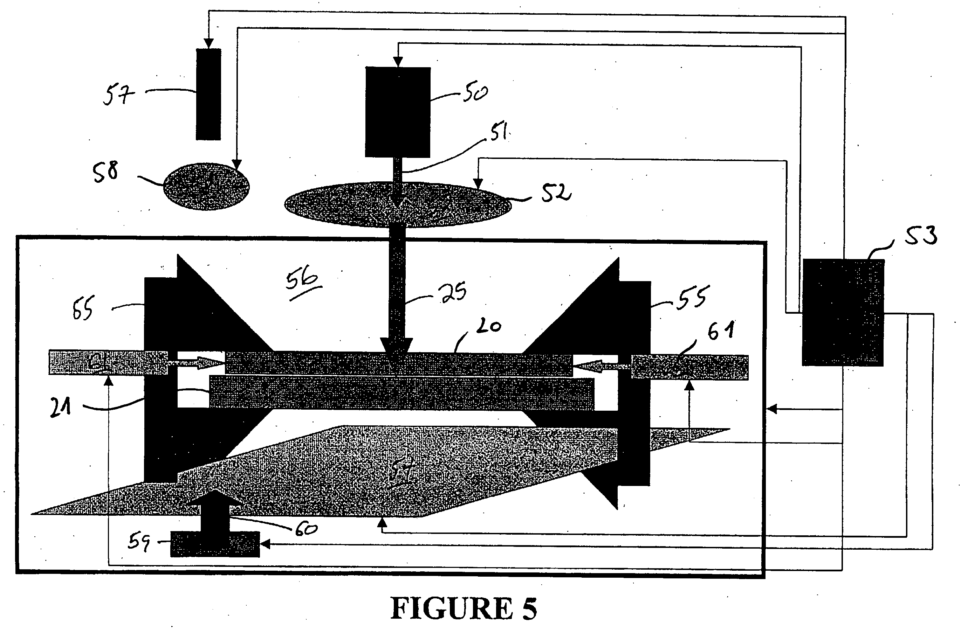

Figure 5 is a schematic diagram illustrating a system for bonding a chip stack and illustrating laser beam projections. Second chip 20 is arranged on top of carrier chip 21 to make a chip stack. Alternatively, the chip stack may be oriented in any other direction. Laser Beam 25 is shown as projecting through second chip 20 to the interface between second chip 20 and carrier chip 21 where it impinges on a bond area situated on either second chip 20 or carrier chip 21. Alternatively, as described above, laser beam 25 may be projected through carrier chip 21 to impinge on the bond areas at the interface between carrier chip 21 and second chip 20. Laser beam 25 originates from laser 50, which emits unfocused laser beam 51. Unfocused laser beam 51 is focused and directed by optics 52 to become laser beam 25. ' Both optics 52 and laser 50 are controlled by processor 53. Processor 53 also controls x-y positioning table 54, which is able to move aperture 55 in the x-y plane. The x-y plane is roughly orthogonal to the direction of laser beam 25. Aperture 55 holds the chip stack and applies a mechanical pressure to second chip 20 and carrier chip 21. Aperture 55 also provides an opening through which laser beam 25 is projected. Alternatively, aperture 55 may be transparent to the wavelength of laser beam 25 and therefore no opening in aperture 55 would be necessary. Chamber 56 encloses the chip stack and aperture 55 and provides a controlled atmosphere for the bonding process. Chamber 56 is controlled by processor 53 and may provide an inert gas atmosphere or another different atmosphere in order to improve the bonding conditions. Additionally, any or all of optics 52, aperture 55, and laser 50 may be integrated with chamber 55.

Also shown in Figure 5 is a system for aligning chip 20 with chip 21 which may include camera 57 and further optics 58 which may both be directed at the edge of the chip stack and may both be connected to processor 53. Light source 59 may project light beam 60 in the direction of the edge of the chip stack and towards further optics 58 and camera 57. Light source 59 may also be connected to and controlled by processor 53. Processor 53 may control alignment adjuster 61 to move chip 20 with respect to chip 21 in the x-y plane (or alternatively to move chip 21 with respect to chip 20 in the x-y plane). In this manner, the bonding areas of chip 20 and chip 21 may be aligned.

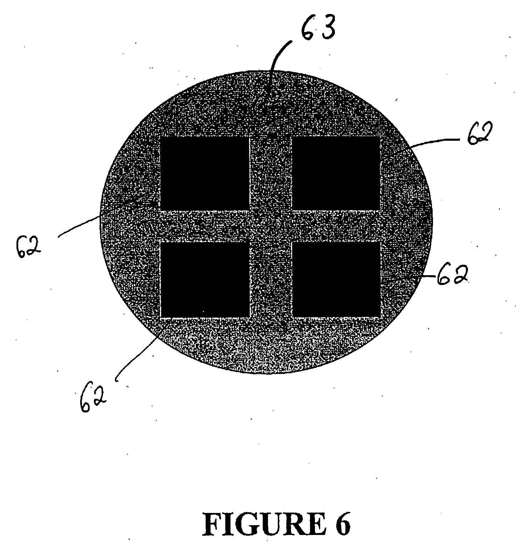

Figure 6 illustrates a relationship between bond area size and laser spot size by showing how bond areas 62 may be smaller than laser spot 63. For example, each bond area 62 may be a square with side lengths of 2 micrometers. Laser spot 63 may be larger than bond area 62, and may illuminate multiple bond areas 63 simultaneously.

An additional medium may be used to enhance contact between the metal layers. The medium may be a surrounding gas (e.g. an inert gas) or a third layer arranged between the metal layers which are to be bonded by laser-induced heat. Enhanced contacting may be achieved by influencing the surface tension of the wetted materials or by adjusting the laser energy absorption of the materials.

Motion in an x-y plane (i.e. approximately orthogonal to the laser beam) of fixed optics and/or the wafer may also be utilized. Scanning the laser beam lateral over the device or wafer surface by moving the wafer underneath the fixed focused laser beam may enable enhanced positioning accuracy and decreased spot size. Grids of bond spots (pads) as well as patterns of bond lines may be created. Fixed focusing optics may allow spot sizes of 1 to 10 microns. Accuracies and speeds may depend on the x-y motioning system.

A method for bonding chips to other chips, chip carriers, substrates, or other wafers is provided herein. While several embodiments have been discussed, others, within the invention's spirit and scope, are also plausible. For instance, production speeds may be increased by utilizing several fiber-delivered or free space laser beams. The multiple laser beams may be focused onto one wafer by individual scanners or by a single or multiple fixed ' focusing optics. Increased productivity of the production system may be proportional to the amount of laser beams working simultaneously.

## Claims

1. A method for bonding a chip to a chip carrier comprising:
arranging the chip in alignment with the chip carrier to form a chip stack, at least one first bond area situated on the chip at an interface between the chip and the chip carrier, at least one second bond area situated on the chip carrier at the interface, the at least one first bond area contacting the at least one second bond area; and
projecting a laser beam through at least one of the chip and the chip carrier, the laser beam impinging on at least one of the at least one first bond area and the at least one second bond area, the laser beam melting at least one of the at least one first bond area and the at least one second bond area, the melting forming at least one bond electrically coupling the chip and the chip carrier.

2. The method according to claim 1, wherein the laser beam is projected through the chip with about zero absorption.

3. The method according to claim 1, wherein the laser beam is projected through the chip carrier with about zero absorption.

4. The method according to claim 1, wherein the laser beam impinges on the at least one first bond area.

5. The method according to claim 1, wherein the laser beam impinges on the at least one second bond area.

6. The method according to claim 1, wherein the laser beam melts the at least one first bond area.

7. The method according to claim 1, wherein the laser beam melts the at least one second bond area.

8. The method according to claim 1, further comprising creating mechanical pressure between the chip and the chip carrier at least one of before and during the laser beam projecting operation.

9. The method according to claim 1, further comprising:
arranging a further chip in alignment with the chip to form an extended chip stack, at least one third bond area situated on the chip at a further interface between the chip and the further chip, at least one fourth bond area situated on the further chip at the further interface, the at least one third bond area contacting the at least one fourth bond area; and
projecting a further laser beam through at least one of the chip stack and the further chip, the further laser beam impinging on at least one of the at least one third bond area and the at least one fourth bond area, the laser beam melting the at least one of the at least one third bond area and the at least one fourth bond area thereby forming at least one further bond electrically coupling the chip and the further chip.

10. The method according to claim 9, wherein the laser beam is projected through the chip and the further chip.

11. The method according to claim 1, further comprising measuring at least one of a resistance and a conductance of the at least one bond.

12. The method according to claim 1, further comprising measuring a temperature at the bond area, wherein the temperature measuring is by at least one of an optical temperature sensor and an infrared temperature sensor.

13. The method according to claim 1, further comprising at least one of:
adjusting the optics to scan the laser beam; and
moving the chip stack on an x-y table.

14. The method according to claim 1, further comprising observing the at least first bond area and the at least one second bond area to determine if the at least one bond is formed, wherein the observing is of at least one of an infrared spectrum, an ultraviolet spectrum, and a visible spectrum.

15. The method according to claim 1, further comprising depositing a metal at at least one of the first bond area and the second bond area before arranging the chip in alignment with the chip carrier.

16. The method according to claim 1, wherein the depositing a metal is at about the same time as the IC is at least one of deposited and patterned.

17. The method according to claim 1, wherein at least one of the first bond area and the second bond area includes silicon.

18. A device, comprising:
a chip having at least one first bond area situated on a chip carrier side of the chip; and
a chip carrier having at least one second bond area situated on a chip side of the chip carrier, the at least one first bond area bonded to the at least one second bond area to form a contact area, wherein the contact area is less than about 4 µm²;
wherein the at least one first bond area is bonded to the at least one second bond area by a laser beam impinging on at least one of the at least one first bond area and the at least one second bond area.

19. The device according to claim 18, wherein at least one of the at least one first bond area and the at least one second bond area includes an absorption layer, the absorption layer able to absorb a laser beam with about zero reflection.

20. The device according to claim 18, wherein the absorption layer includes nitride.

21. The device according to claim 18, wherein the laser beam projects through at least one of the chip and the chip carrier with about zero absorption.

22. The device according to claim 18, wherein at least one of the at least one first bond area and the at least one second bond area has a diameter of between about 1 micrometer and about 10 micrometers.

23. The device according to claim 18, wherein a metal is arranged at at least one of the first bond area and the second bond area

24. The device according to claim 23, wherein the metal includes at least one of Al, AlSi, AlSiCu, Cu, and Ge.

25. The device according to claim 18, wherein at least one of the first bond area and the second bond area includes silicon.

26. The device according to claim 18, wherein the chip carrier includes at least one of:
a base chip;
a ceramic thick film substrate;
a printed circuit board having at least one bonding area compatible to the chip; and
a substrate having at least one bonding area.

27. The device according to claim 18, further comprising:
a further chip having at least one third bond area situated on a second chip side of the further chip;
wherein the chip has at least one fourth bond area on a further chip side of the chip; and
wherein the at least one third bond area is bonded to the at least one fourth bond area by a further laser beam impinging on at least one of the at least one third bond area and the at least one fourth bond area.

28. The device according to claim 27, wherein the laser beam projects through the chip and the further chip with about zero absorption.

29. The device according to claim 27, wherein the further laser beam projects through the further chip with about zero absorption.

30. The device according to claim 27, wherein the further laser beam projects through the chip and the chip carrier with about zero absorption.

31. The device according to claim 18, wherein:
the at least one first bond area is a single first bond area;
the at least one second bond area is a single second bond area; and
the single first bond area bonds to the single second bond area to form a single electrical bond.

32. The device according to claim 18, wherein:
the at least one first bond area includes a plurality of first bond areas;
the at least one second bond area includes a plurality of second bond areas; and
the plurality of first bond areas bonds to the plurality of second bond areas to form a plurality of electrical bonds.

33. The device according to claim 18, wherein:
the at least one first bond area includes a first bond line;
the at least one second bond area includes a second bond line; and
the first bond line bonds to the second bond line to form a linear electrical bond.

34. A system for bonding a chip to a chip carrier, comprising:
at least one laser; and
an aperture for holding a chip stack in alignment, the chip stack including a chip and a chip carrier;
wherein the at least one laser projects a laser beam through at least one of the chip and the chip carrier, the laser beam impinging on at least one of at least one first bond area and at least one second bond area, the at least one first bond area situated on a chip carrier side of the chip, the at least one second bond area situated on a chip side of the chip carrier, the at least one first bond area contacting the at least one second bond area; and
wherein the at least one first bond area is bonded to the at least one second bond area by the laser beam impinging on the at least one of the at least one first bond area and the at least one second bond area.

35. The system according to claim 34, wherein the laser beam impinges on the at least one first bond area.

36. The system according to claim 34, wherein the laser beam impinges on the at least one second bond area.

37. The system according to claim 34, wherein the laser beam projects through the chip with about zero absorption.

38. The system according to claim 34, wherein the laser beam projects through the chip carrier with about zero absorption.

39. The system according to claim 34, further comprising at least one of
at least one optic for at least one of directing and focusing the laser beam;
an arrangement configured to create mechanical pressure between the chip and the chip carrier; and
an x-y table for at least one of moving the chip stack in an x-y plane and moving the at least one laser in an x-y plane, the x-y plane about orthogonal to the laser beam

40. The system according to claim 34, wherein the at least one laser is directed at the chip stack at an angle less than 90 degrees.

41. The system according to claim 34, further comprising at least one further laser for emitting at least one further laser beam.

42. The system according to claim 41, further comprising at least one further optic corresponding to each further laser for at least one of directing and focusing the at least one further laser beam.

43. The system according to claim 41, further comprising an integrated optic able to direct the laser beam and the at least one further laser beam at the chip stack.

44. The system according to claim 41, wherein the at least one further laser is directed at the extended chip stack at an angle less than 90 degrees.

45. The system according to claim 34, further comprising at least one of:
a vision system for determining if the bonding is complete, wherein the vision system operates in at least one of an infrared spectrum, an ultraviolet spectrum, and a visible spectrum;
a temperature sensor for determining a temperature at at least one of the at least one first bond area and the at least one second bond area, wherein the temperature sensor is at least one of an optical temperature sensor and an infrared temperature sensor; and
an arrangement configured to measure at least one of a resistance and a conductance between the at least one first bond area and the at least one second bond area.

46. The system according to claim 34, wherein the laser beam has a wavelength of about 1200 nanometers.

47. The system according to claim 34, wherein the laser beam has a wavelength of about 1600 nanometers.

48. The system according to claim 34, wherein the at least one laser includes at least one of:
a fiber laser having a power of between about 1 watt and about 100 watts, wherein the fiber laser includes a bundle of gallium/arsenide diodes;
a laser projecting a continuous laser beam; and
a laser projecting a pulsed laser beam.
